## Europäisches Patentamt
## European Patent Office
## Office européen des brevets

(11) Veröffentlichungsnummer: **0 092 821**
**B1**

(12) # EUROPÄISCHE PATENTSCHRIFT

(45) Veröffentlichungstag der Patentschrift:
31.07.85

(51) Int. Cl.⁴: **H 03 K 19/003**, H 03 K 19/086

(21) Anmeldenummer: **83103970.6**

(22) Anmeldetag: **22.04.83**

(54) **Verknüpfungsglied mit einem Emitterfolger als Eingangsschaltung.**

(30) Priorität: **26.04.82 DE 3215518**

(43) Veröffentlichungstag der Anmeldung:
**02.11.83 Patentblatt 83/44**

(45) Bekanntmachung des Hinweises auf die Patenterteilung:
**31.07.85 Patentblatt 85/31**

(84) Benannte Vertragsstaaten:
**FR GB NL**

(56) Entgegenhaltungen:
**DER FERNMELDE-INGENIEUR, Band 27, Nr. 7, Juli 1973, Bad Windsheim**

(73) Patentinhaber: **Siemens Aktiengesellschaft, Berlin und München Wittelsbacherplatz 2, D-8000 München 2 (DE)**

(72) Erfinder: **Barré, Claude, Dipl.-Ing., Implerstrasse 23, D-8000 München 70 (DE)**

**Beschreibung**

Die Erfindung bezieht sich auf ein Verknüpfungsglied nach dem Oberbegriff des Patentanspruchs.

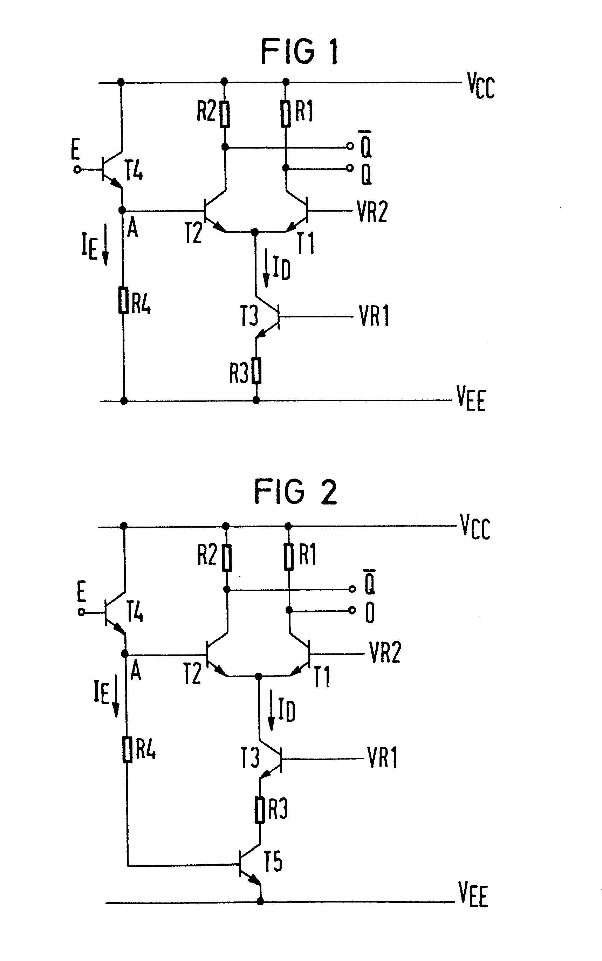

Derartige Verknüpfungsglieder sind unter den Bezeichnungen ECL und E²CL allgemein bekannt (vergleiche »Der Fernmelde-Ingenieur«, Heft 7, Juli 1973, Seite 20 und 21, insbesondere Bild 13 und 14). Während bei ECL-Schaltungen den Steuereingängen der für die emittergekoppelte Logik typischen Differenzverstärker Emitterfolger zum Zweck der Signalpegelverschiebung nur in Verbindung mit der sogenannten Serienkopplung vorgeschaltet werden, sind bei E²CL-Schaltungen häufig mehrere Emitterfolger parallel geschaltet und mit einem gemeinsamen Emitterwiderstand ausgestattet. Neben einer Signalpegelverschiebung bewirken dann die Emitterfolger die logische ODER-Verknüpfung entsprechend vieler Eingangssignale. Die Fig. 1 der Zeichnung zeigt ein bekanntes Ausführungsbeispiel mit einem Emitterfolger.

Ein Differenzverstärker mit den emittergekoppelten Transistoren T1 und T2 und den Kollektor-Arbeitswiderständen R1 und R2 wird mit einem konstanten Strom $I_D$ gespeist, der durch eine aus dem Transistor T3 und dessen Emitterwiderstand R3 bestehende Konstantstromquelle stabilisiert wird. Die Basis des Stromquellentransistors T3 liegt an einem ersten festen Referenzpotential VR1. Durch ein zweites festes Referenzpotential VR2 wird die Basis des einen Transistors T1 des Differenzverstärkers festgehalten. An den Verbindungsstellen der Arbeitswiderstände R1 und R2 mit den Kollektoren der Transistoren T1 und T2 des Differenzverstärkers sind die Ausgangssignale Q und Q̄ abnehmbar.

Der schon erwähnte, für E²CL-Verknüpfungsglieder typische Emitterfolger zur Ansteuerung der Basis des zweiten Transistors T2 des Differenzverstärkers besteht aus dem Transistor T4 und dem Emitter-Arbeitswiderstand R4. An der Basis des Emitterfolgertransistors T4 liegt ein Eingangssignal E.

Bei der Hintereinanderschaltung mehrerer Verknüpfungsglieder in Stromumschaltetechnik unterscheiden sich ECL-Glieder und E²CL-Glieder hinsichtlich der Aufeinanderfolge von Emitterfolger und Differenzverstärker nicht mehr. Ein Unterscheidungskriterium, das im vorliegenden Zusammenhang jedoch nicht näher interessiert, besteht allenfalls in der Realisierung von ODER-Verknüpfungen.

Ergänzend ist noch darauf hinzuweisen, daß vielfach anstelle einer aus Transistor und Emitterwiderstand bestehenden Konstantstromquelle für den Differenzverstärker ein im Vergleich zu den Kollektor-Arbeitswiderständen R1, R2 hochohmiger Widerstand eingesetzt wird. Andererseits wird auch gelegentlich der ohmsche Emitterwiderstand (R4) im Emitterfolger durch eine Stromquellenschaltung ersetzt.

Für die Umladung der Kapazität des Knotens A (Fig. 1) bei einer fallenden Signalflanke am Eingang E wird ein Strom $I_E$ benötigt, der für npn-Transistoren die in Fig. 1 durch einen Pfeil bezeichnete Richtung hat. Fehlt dieser Vorstrom $I_E$ infolge eines Fehlers bei der Herstellung eines integrierten Bausteins, beispielsweise wegen einer Unterbrechung der Verbindungsleitungen zum Emitterwiderstand R4, oder ist er gegen den Sollwert stark verringert, dann kann das zu einer Verlängerung des durch eine abfallende Flanke des Eingangssignals E verursachten Übergangs der Ausgangssignale Q bzw. Q̄ von dem einen zu dem anderen binären Signalpegel um den Faktor hundert und mehr führen, ohne daß der Fehler bei einer statischen Prüfung erkannt wird, weil der Differenzverstärker gerade noch richtig reagiert. Die Folge davon ist die Notwendigkeit der Einführung einer kostenintensiven dynamischen Prüfung oder die Hinnahme des Risikos eines dynamischen Fehlverhaltens der nur teilweise geprüften Schaltung.

Der Erfindung liegt die Aufgabe zugrunde, die bekannte Schaltungsanordnung bei vernachlässigbarem Mehraufwand und unter Beibehaltung aller dynamischen Eigenschaften so zu verändern, daß Fehler der genannten Art auch durch eine rein statische Prüfung sicher erkannt werden. Gemäß der Erfindung wird diese Aufgabe durch die Merkmale im kennzeichnenden Teil des Patentanspruchs gelöst.

Die Fig. 2 der Zeichnung zeigt hierzu ein Ausführungsbeispiel. Soweit dessen Bauelement mit den Bauelementen der bekannten Schaltungsanordnung nach Fig. 1 identisch sind, wurden auch gleiche Bezeichnungen gewählt.

Bei dem erfindungsgemäßen Ausführungsbeispiel ist zwischen der aus dem Transistor T3 und seinem Emitterwiderstand R3 bestehenden Konstantstromquelle zur Speisung des Differenzverstärkers und dem emitterseitigen Anschluß $V_{EE}$ der Versorgungsspannung die Kollektor-Emitter-Strecke eines zusätzlichen Transistors T5 eingefügt. Der nicht mit dem Emitter des als Emitterfolger betriebenen Transistors T4 verbundene Anschluß des Emitterwiderstands R4 ist an die Basis des zusätzlichen Transistors T5 geführt. Der Strom $I_E$ wird durch entsprechende Wahl des Emitterwiderstands R4 bzw. durch die Dimensionierung der ihn ersetzenden Konstantstromquelle zweckmäßig so festgelegt, daß der zusätzliche Transistor T5 im Normalfall gerade schon im Sättigungsbereich arbeitet.

Ist nun infolge eines Fehlers der Vorstrom $I_E$ wesentlich kleiner als sein Sollwert oder fehlt er ganz, dann macht sich das durch eine Verringerung oder den Wegfall des Spannungsabfalls bemerkbar, der als Funktion des Eingangssignals E jeweils an einem der Arbeitswiderstände R1 oder R2 auftreten und einen vorgegebenen Sollwert erreichen müßte. Die gleichen Symptome ergeben sich, wenn infolge eines Fertigungsfehlers der Eingang E offen ist.

Ein wesentlicher Vorteil der erfindungsgemäßen Schaltungsanordnung ist auch darin zu se-

hen, daß ein unbenutzter Differenzverstärker mit vorgeschaltetem Emitterfolger, dessen Eingang E absichtlich nicht abgeschlossen ist, keine Verlustleistung verbraucht. Solche Fälle kommen besonders in programmierbaren Logikanordnungen häufig vor.

## Patentanspruch

Verknüpfungsglied in Stromumschaltetechnik mit einem Emitterfolger (T4) bzw. mit mehreren parallel geschalteten Emitterfolgern als Eingangsschaltung und mit mindestens einem aus einer Konstantstromquelle (T3, R3) gespeisten Differenzverstärker aus emittergekoppelten Transistoren (T1, T2), die wechselseitig gesperrt bzw. leitend gesteuert sind, dadurch gekennzeichnet, daß zwischen dem emitterseitigen Anschluß ($V_{EE}$) der Versorgungsspannung der Konstantstromquelle (T3, R3) die Kollektor-Emitter-Strecke eines im Normalzustand gesättigten weiteren Transistors (T5) eingefügt ist, dessen Basiselektrode über Schaltmittel (R4) zur Erzeugung eines wenigstens annähernd konstanten Vorstroms ($I_E$) für den Emitterfolger bzw. für die Emitterfolger mit dem Emitter des als Emitterfolger betriebenen Transistors (T4) bzw. mit den Emittern der als Emitterfolger betriebenen Transistoren verbunden ist

## Claim

A logic element in current switching technology having an emitter follower stage (T4) or a plurality of parallel emitter follower stages as an input circuit, and having at least one differential amplifier fed from a constant current source (T3, R3) and consisting of emitter-coupled transistors (T1, T2) which are alternately blocked or controlled to conduct, as the case may be, characterised in that between the emitter-end supply voltage terminal ($V_{EE}$) and the constant current source (T3, R3), there is inserted the collector-emitter path of a further transistor (T5) which in the normal state is saturated, and in order to generate an at least approximately constant initial current ($I_E$) for the emitter follower or for the emitter followers, as the case may be, the base electrode of this further transistor (T5) is connected via an intermediate circuit (R4) to the emitter of the emitter follower transistor stage (T4) or to the emitters of the emitter follower transistor stages as the case may be.

## Recendication

Circuit logique réalisé suivant la technique de commutation du courant comportant un émetteur-suiveur (TA) ou plusieurs émetteurs-suiveurs branchés en parallèle et servant de circuit d'entrée, et ou moins un amplificateur différentiel, alimenté par une source de courant constant (T3, R3) et constitué par des transistors (T1, T2) à émetteurs couplés qui sont en alternance bloqués et placés à l'état conducteur, caractérisé par le fait qu'entre le borne ($V_{EE}$), située du côté émetteur, de la tension d'alimentation et la source de courant constant (T3, R3) se trouve insérée la voie collecteur-émetteur d'un transistor supplémentaire (T5), saturé dans son état normal et dont L'électrode de base est reliée par l'intermédiaire de moyens de commutation (R4) à l'émetteur du transistor (T4) fonctionnant en tant qu'émetteur-suiveur ou aux émetteurs des transistors fonctionnant et tant qu'émetteurs-suiveurs, pour la production d'un courant de polarisation ($I_E$) au moins approximativement constant pour le ou les émtteurs-suiveurs.

# FIG 1

# FIG 2